# EUROPEAN PATENT APPLICATION

(11) **EP 1 329 290 A2**
(43) Date of publication of application: **23.07.2003**
(21) Application number: 03075541.7
(22) Date of filing: 15.05.2000
(51) Int. Cl.: B24B 37/04, B24D 13/14

(54) **Chemical mechanical planarization or polishing pad with sections having varied groove patterns**

(30) Priority: 21.05.1999 US 316166
(62) Divisional of application: 00930746.3
(71) Applicant: LAM RESEARCH CORPORATION, Fremont, CA 94538-6470 (US)
(72) Inventor: Jensen, Alan J., Troutdale, OR 97060 (US); Thornton, Brian, Santa Clara, CA 95054 (US)
(74) Representative: Bucks, Teresa Anne

(57) **Abstract**

The present invention relates to a polishing pad (310) for use in chemical mechanical planarization applications. More particularly, the present invention relates to a pad used in the chemical mechanical planarization or polishing of semiconductor wafers.

A rotary polishing pad for chemical mechanical planarization of a semiconductor wafer, the rotary polishing pad comprising at least two polishing pad sections serially linked along a rotational path of the rotary polishing pad (310), the polishing pad sections (312) comprising a first polishing pad section having a first groove pattern (316b) formed in an outer surface of the polishing pad, wherein the first groove pattern (316b) comprises a plurality of grooves and a second polishing pad section having a second groove pattern (316a) formed in the outer surface of the polishing pad section wherein the second groove pattern comprises a second plurality of grooves and the first groove pattern differs from the second groove pattern.

## Description

### FIELD OF THE INVENTION

The present invention relates to a polishing pad for use in chemical mechanical planarization applications. More particularly, the present invention relates to a pad used in the chemical mechanical planarization or polishing of semiconductor wafers.

### BACKGROUND OF THE INVENTION

Semiconductor wafers typically fabricated with multiple copies of a desired integrated circuit design that will later be separated and made into individual chips. A common technique for forming the circuitry on a semiconductor is photolithography. Part of the photolithography process requires that a special camera focus on the wafer to project an image of the circuit on the wafer. The ability of the camera to focus on the surface of the wafer is often adversely affected by inconsistencies or unevenness in the wafer surface. This sensitivity is accentuated with the current drive toward smaller, more highly integrated circuit designs. Semiconductor wafers are also commonly constructed in layers, where a portion of a circuit is created on a first level and conductive vias are made to connect up to the next level of the circuit. After each layer of the circuit is etched on the wafer, an oxide layer is put down allowing the vias to pass through but covering the rest of the previous circuit level. Each layer of the circuit can create or add unevenness to the wafer that is preferably smoothed out before generating the next circuit layer.

Chemical mechanical planarization (CMP) techniques are used to planarize the raw wafer and each layer of material added thereafter. Available CMP systems, commonly called wafer polishers, often use a rotating wafer holder that brings the wafer into contact with a polishing pad moving in the plane of the wafer surface to be planarized. A polishing fluid, such as a chemical polishing agent or slurry containing microabrasives, is applied to the polishing pad to polish the wafer. The wafer holder then presses the wafer against the rotating polishing pad and is rotated to polish and planarize the wafer.

The type of polishing pad used on the wafer polisher can greatly affect the removal rate profile across a semiconductor wafer. Ideally, a semiconductor wafer processed in a wafer polisher will see a constant removal rate across the entire wafer surface. Many polishing pads have been designed with one particular pattern of channels or voids to attempt to achieve a desired removal rate. It is known from JP06047678A to have a polishing member for use in chemical mechanical planarization of a semiconductor wafer which comprises a linear belt, which belt is movable in a linear path.

These existing polishing pads often have a signature removal rate pattern that, for example, may remove material from the edge of a semiconductor wafer faster than the inner portion of the wafer. Accordingly, there is a need for a polishing pad that will enhance uniformity across the surface of a semiconductor wafer.

### SUMMARY OF THE INVENTION

According to the present invention there is provided a rotary polishing pad for chemical mechanical planarization of a semiconductor wafer, the rotary polishing pad comprising at least two polishing pad sections serially linked along a rotational path of the rotary polishing pad, the polishing pad sections comprising a first polishing pad section having a first groove pattern formed in an outer surface of the polishing pad section, wherein the first groove pattern comprises a plurality of grooves and a second polishing pad section having a second groove pattern formed in the outer surface of the polishing pad section wherein the second groove pattern comprises a second plurality of grooves and the first groove pattern differs from the second groove pattern.

### BRIEF DESCRIPTION OF THE DRAWINGS

Fig. 1 is a plan view of a rotary polishing pad according to a preferred embodiment;
Fig. 2 is a graphical representation of material removal rate measurements made according to a preferred embodiment of the method of the present invention; and
Fig. 3 is a graphical representation of the material removal rates obtained by combining selected polishing pad sections.

### DETAILED DESCRIPTION OF THE PRESENTLY PREFERRED EMBODIMENTS

One more important factor in a chemical mechanical planarization (CMP) process is the uniformity of the resulting polish across the surface of a semiconductor wafer. By leaving uniform material thickness at all points on the wafer after completion of the polishing process, an integrated circuit die on the wafer will be more likely to maintain the same performance characteristics independent of where it originated on the wafer. As set forth below, a CMP polishing pad according to an embodiment of the present invention provides improved uniformity in removal rates and can lead to improved manufacturing process control and increased wafer yield.

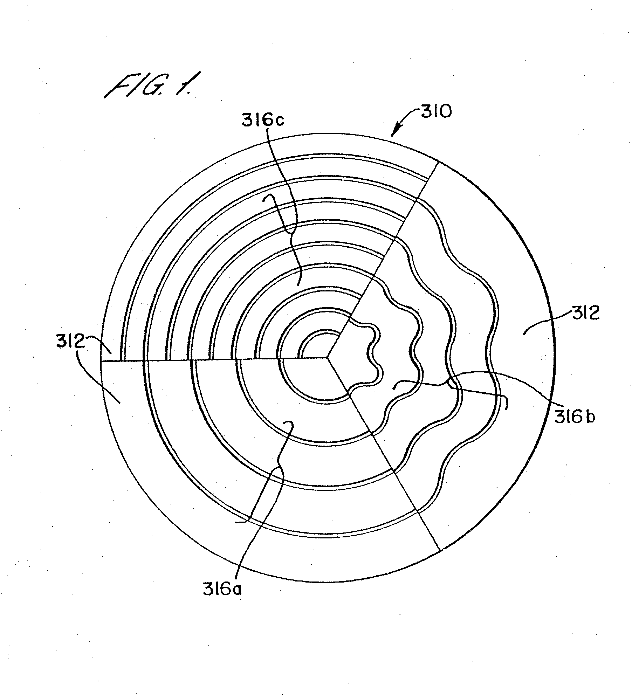

Fig. 1 illustrates a presently preferred embodiment of a rotary CMP polishing pad 310 according to the present invention. The polishing pad 310 includes a plurality of polishing pad sections 312. Each polishing pad section 312 is positioned adjacent to the next. Each pad section 312 may be constructed from a separate piece of pad material and connected together to form the complete polishing pad 310. Alternatively the polishing pad sections 312 may be manufactured in a single piece of material. The polishing pad sections may either be mounted on a separate member or may form a polishing pad that is a stand-alone member.

Each groove pattern, in one preferred embodiment, is defined by a width, a depth, and a pitch.

The width of a groove is the distance between opposing parallel walls of the groove. The depth is the distance from the outer surface of the polishing pad to the bottom of the groove, and the pitch is the distance for a first wall of a first groove to a respective first wall of the immediately adjacent groove. The groove pattern differs between pad sections but is preferably uniform within a given pad section 312 so that the width, depth and pitch are the same for grooves within a particular pad section. In other embodiments, the groove pattern within a particular pad section may include a width, depth and pitch that varies between grooves in the pad section. Additionally, while the grooves are preferably formed having a rectilinear cross-section, the grooves may be formed having slanted or curved walls. For purposes of this specification, a groove is defined as a channel that is cut or formed in the pad material where the length of the channel is greater than its width. A groove may or may not extend the entire length of a pad section.

The grooves in a particular pad section may be non-parallel. The non-parallel groove pattern 316b may have grooves that intersect. The polishing pad section with the non-parallel groove pattern may be combined with other polishing pad sections having parallel groove patterns. Other combinations, such as a polishing pad with all pad sections having a different, non-parallel groove pattern or a polishing pad with some pad sections having non-parallel grooves and other pad sections having non-grooved surfaces, are contemplated.

Fig. 1 illustrates one rotary polishing pad 310 having a plurality of wedge-shaped sections 312 that are serially linked such that a semiconductor wafer is sequentially presented with a different section as the rotary polishing pad is rotated. Each section 312 preferably has a different groove pattern 316a-316c. In one embodiment, one or more sections 312 may each have a groove pattern that includes a plurality of concentric arc segments (see groove patterns 316a and 316c) centered about the center of the rotary pad. In other embodiments, one or more sections 312 may have a groove pattern including a plurality of non-concentric groove patterns.

One suitable pad material for use in constructing the polishing pad is a closed cell polyurethane such as IC1000 available from Rodel Corporation of Phoenix, Arizona. Although each pad section is preferably constructed of the same pad material, in other embodiments one or more different pad materials may be used for each polishing pad section in the polishing pad. The pad materials may also be selected to have a different hardness or densities. In one preferred embodiment, the pad materials may have a Durometer hardness in the range of 50-70, a compressibility in the range of 4%-16%, and a specific gravity in the range of 0.74-0.85. The grooves may be fabricated in the pad material using standard techniques used by any of a number of commercial semiconductor wafer polishing pad manufacturers such as Rodel Corp.

One preferred method for creating a CMP polishing pad having a substantially uniform material removal rate profile for a semiconductor wafer is described below. First, several polishing pads, each having a single groove pattern and each completely covering the circumference of a different pad, are each used to polish a semiconductor wafer for a predetermined time. A wafer polisher, preferably the TERES ™ polisher available from Lam Research Corporation, is used to test each of the polishing pads. After polishing a semiconductor wafer with a particular polishing pad, the amount of material removed is measured at various points across the diameter of the wafer and recorded in a database on a computer. The removal rates are then compared at the respective measurement points used for each semiconductor wafer. Using the comparison data, a determination is made as to what combination of groove patterns, and what length of each particular groove pattern, is predicted to produce a uniform material removal rate across an entire semiconductor wafer. In one preferred embodiment, the comparison of the material removal rates and determination of the appropriate combination of groove patterns may be accomplished using a personal computer running a program written in Excel by Microsoft Corporation.

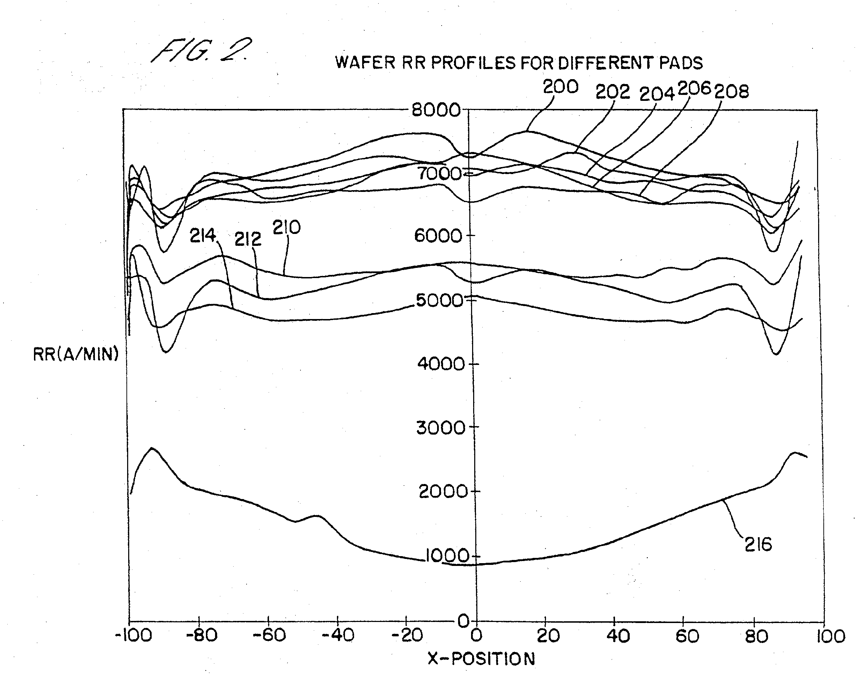

A graphical representation of material removal rates for various groove patterns is illustrated in Fig. 2. The x-axis of the graph in Fig. 2 represents the measurement point along the diameter of the semiconductor wafer in millimetres from the center of the wafer. The y-axis represents the measured removal rate in angstroms per minute. Each trace on the graph represents the measured removal rate for a pad having a particular groove pattern. The downforce (pressure applied to the semiconductor against the pad) for all measurements was 5 pounds per square inch, while the linear speed of the pad and the rotational speed of the wafer holder were 400 feet per minute and 20 revolutions per minute, respectively. Beginning with the uppermost trace in Fig. 2, the groove patterns corresponding to the illustrated material removal rates are as follows:

| Reference Number | Groove Pattern (width x depth x pitch) (all in thousandths of an inch) |
|---|---|
| 200 | K-Groove ^{tm} |
| 202 | 10x20x40 |
| 204 | 10x20x100 |
| 206 | 20x20x50 |
| 208 | 10x10x100 |
| 210 | 20x20x40 |
| 212 | 10x20x50 |
| 214 | 20x20x100 |
| 216 | No Grooves In Pad |

As is apparent from the example of Fig. 2, the material removal rate and the removal rate profile vary significantly between the different groove patterns. By selecting several groove patterns and calculating a weighted average of removal rates at each point along the diameter of the wafer, where the weighting is based on the percentage of length of the complete pad that will be constructed from a pad section having the particular groove pattern, a predicted removal rate profile may be calculated. While various groove dimensions are contemplated, the groove dimensions are preferably within the range of 0-30 thousandths of an inch (mils) wide, 5-30 mils deep, and have a pitch in the range of 25-200 mils. The K-Groove™ trace 200 refers to a commercially available groove pattern from Rodel Corp.

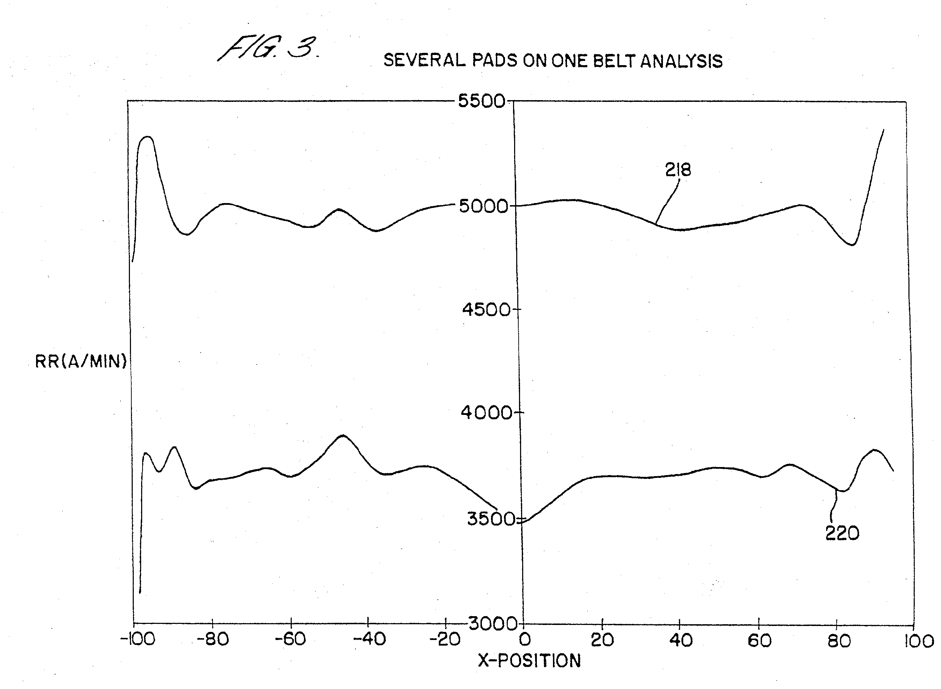

Fig. 3 illustrates a predicted removal rate profile 218 and the actual removal rate profile 220 measured from a polishing pad fabricated according to the method described above. The polishing pad used to generate the removal rate profiles 218, 220 included three equal sized polishing pad sections and constructed out of the same polishing pad material. The first polishing pad section included a groove pattern of 0.010" x 0.020" x 0.100" (depth x width x pitch), the second polishing section included a groove pattern of 0.020" x 0.020" x 0.050", and the third polishing pad section had no grooves. Another polishing pad, fabricated according to a preferred embodiment of the present invention, having improved material removal rate uniformity along the entire width of the wafer, is made up of five polishing pad sections: no groove, 12 x 20 x 50, 20 x 20 x 50, 10 x 20 x 100, and 20 x 20 x 100 (where the dimensions are in thousandths of an inch and refer to width x depth x pitch).

From the foregoing, a polishing pad and a method of making the same have been described. The method takes advantage of the different material removal rate profiles of different groove patterns and optimizes a combination of the available groove patterns to form a composite pad having at least two polishing pad sections with different groove patterns. The method provides for comparing removal rate profiles for different groove patterns and mathematically optimizing a resulting combination of polishing pad sections on a single platform to improve the removal rate profile. The resulting pad preferably has a more uniform material removal rate across a semiconductor wafer.

A CMP polishing pad is also disclosed having a plurality of serially linked polishing pad sections. The pad sections form the rotary polishing pad. Each polishing pad section includes a different groove pattern that, in a first embodiment, is made up of grooves oriented parallel to the direction of travel of the pad and, in another embodiment, may include grooves that are not parallel to the direction of travel.

It is intended that the foregoing detailed description be regarded as illustrative rather than limiting, and that it be understood that the following claims, including all equivalents, are intended to define the scope of this invention.

## Claims

**1.** A rotary polishing pad (310) for chemical mechanical planarization of a semiconductor wafer, the rotary polishing pad comprising:
at least two polishing pad sections (312) serially linked along a rotational path of the rotary polishing pad, the polishing pad sections (312) comprising:
a first polishing pad section having a first groove pattern (316b) formed in an outer surface of the polishing pad, wherein the first groove pattern (316a) comprises a plurality of grooves; and
a second polishing pad section having a second groove pattern (316a) formed in the outer surface of the polishing pad section wherein the second groove pattern (316a) comprises a second plurality of grooves and the first groove pattern (316b) differs from the second groove pattern (316a).

**2.** The polishing pad (310) of claim 1, wherein the first groove pattern (316b) comprises a plurality of non-parallel grooves.

**3.** The polishing pad (310) of claim 1, wherein the second groove pattern (316b) comprises a plurality of parallel grooves.

**4.** The polishing pad (310) of claim 1, wherein each polishing pad section (312) comprises a wedge-shaped section.

**5.** The polishing pad (310) of claim 1, wherein the first groove section (316a) comprises a plurality of grooves, the plurality of grooves having a constant width and a constant depth.

**6.** The polishing pad (310) of claim 5 wherein each of the plurality of grooves further comprises a constant spacing between adjacent grooves.

**7.** The rotary polishing pad (310) of claim 1, wherein the plurality of grooves in the first polishing pad section comprises a plurality of concentric arc segments centered about a center of rotation of the rotary polishing pad (310).

**8.** The rotary polishing pad (310) of claim 7, wherein the second plurality of grooves comprises a second plurality of concentric arc segments centered about a center of rotation of the rotary polishing pad (310).

**9.** The rotary polishing (310) pad of claim 1, wherein the first and second polishing pad sections (312) comprise different levels of hardness.

**10.** The rotary polishing pad (310) of claim 1, wherein the first and second polishing pad sections (312) comprise different densities.

**11.** The rotary polishing pad (310) of claim 1, wherein the first and second polishing pad sections (312) comprise different material removal profiles, and wherein the polishing pad sections (312) are selected to produce a polishing member having a substantially uniform material removal profile.

**12.** The rotary polishing pad (310) of claim 1, wherein each of the first plurality of grooves comprises:
a rectangular cross section having a depth defined by a distance from the surface of the polishing pad (312), a width defined by a distance perpendicular to

**12.** The rotary polishing pad (310) of claim 1, wherein each of the first plurality of grooves comprises:
a rectangular cross section having a depth defined by a distance from the surface of the polishing pad (310), a width defined by a distance perpendicular to the depth measured from a first groove wall to a second groove wall, and a pitch spacing defined by a distance between the first groove wall of a first groove in the first plurality of grooves and a respective first wall of a groove immediately adjacent to the first groove.

**13.** The rotary polishing pad (310) of claim 12, wherein at least one of the depth, the width, and the pitch of grooves of the first polishing pad section differs from a respective depth, width, and pitch of grooves of the second polishing pad section.

**14.** The rotary polishing pad (310) of claim 1, wherein the pitch of the grooves is uniform across the first polishing pad section.

**15.** The rotary polishing pad of claim 1, wherein the pitch of the grooves varies across the first polishing pad section.
